(19)

Europäisches
Patentamt
European
Patent Office
Office européen
des brevets

(11) **EP 2 169 680 A1**

(12) **EUROPEAN PATENT APPLICATION**

(43) Date of publication:
**31.03.2010 Bulletin 2010/13**

(51) Int Cl.:
***G11B 20/14*** *(2006.01)*

(21) Application number: **08305613.5**

(22) Date of filing: **30.09.2008**

(84) Designated Contracting States:
**AT BE BG CH CY CZ DE DK EE ES FI FR GB GR HR HU IE IS IT LI LT LU LV MC MT NL NO PL PT RO SE SI SK TR**
Designated Extension States:
**AL BA MK RS**

(71) Applicant: **Thomson Licensing**
**92443 Issy-les-Moulineaux Cedex (FR)**

(72) Inventors:
• **Chen, Xiao-Ming**
**30165 Hannover (DE)**

• **Theis, Oliver**
**30655 Hannover (DE)**
• **Timmermann, Friedrich**
**30823 Garbsen (DE)**

(74) Representative: **Thies, Stephan**
**Deutsche Thomson OHG**
**European Patent Operations**
**Karl-Wiechert-Allee 74**
**30625 Hannover (DE)**

(54) **Method for encoding, method for decoding, and method for generating a parity check matrix**

(57) The invention proposes an approach, where on the recording side, after conventional ECC encoding, parity bits aiming at typical error pattern correction are inserted first, after which the resulting bitstream is channel modulated. Correspondingly, at the readback side, the parity-based postprocessing takes place after channel demodulation.

Fig. 2

EP 2 169 680 A1

**Description**

Field of the invention

The invention relates to the field of parity-check codes and parity-based post processing.

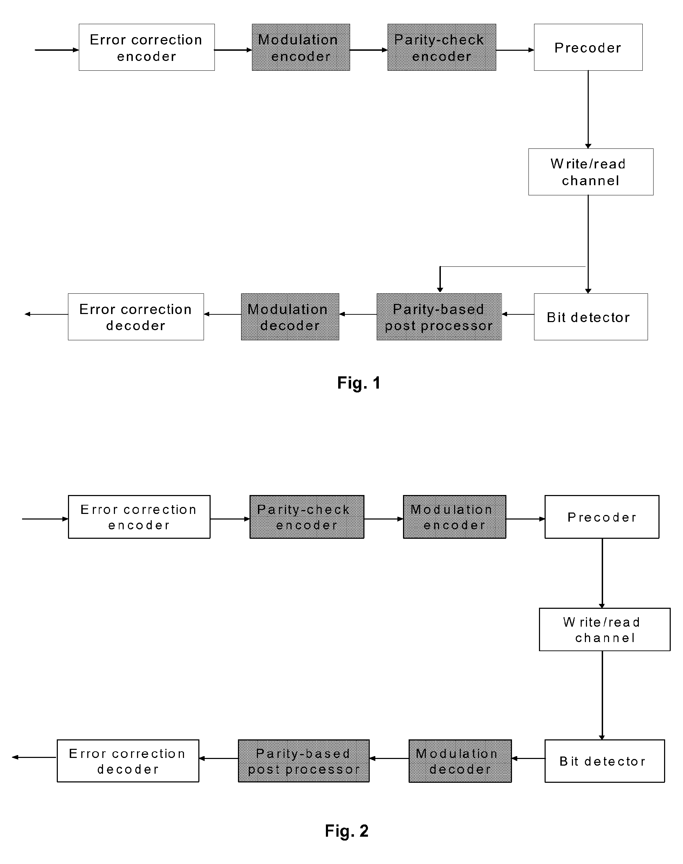

For reliable data recovery, advanced bit detection techniques such as partial response maximum likelihood (PRML) or noise predictive maximum likelihood (NPML) are employed in high-density data storage systems. To improve system performance further, parity-based post processing has been proposed for example in "Noise predictive maximum likelihood detection combined with parity-check based post processing," by Cideciyan et al, IEEE Trans. Magn., vol. 37, pp. 714-720, Mar. 2001, for magnetic storage systems and in "Parity-check codes and post-processing for d=1 optical recording channels," by Cai et al, IEEE Trans. Magn., vol. 41, pp. 4338-4340, Nov. 2005, for optical storage systems. Saeki et al have also disclosed parity-based post bit detector processing in U.S. Patent No. 6581184. These schemes use simple parity-check codes to detect dominant error patterns after bit detector, where a post processor is employed to correct these error patterns. A corresponding simplified system setup is illustrated in Fig. 1.

Fig. 1 shows a prior art system setup for post-detector processing: The parity-check encoder is placed after the modulation encoder and the parity-based post processor is placed directly after the bit detector.

Parity-based post processing evaluates cross correlation between the noisy PR signal and reconstructed PR signals based on bit decisions from the bit detector and predetermined error patterns at different positions (Such error patterns are dominant errors after bit detector and can be determined by means of either simulations or theoretical analysis). Based on cross-correlation values, the type, the polarity, and the position of the maximally likely error events can be identified for error correction.

It is known in optical as well as magnetic recording to regularly insert, at the recording side, some parity bits after channel modulation, aiming to allow a postprocessing at the readback side which corrects the most probable error events. An example is described in US 6,581,184**.**

The known approach of regularly inserting, at a recording side, parity bits into a channel modulated bitstream, can be seen to have the following drawbacks:

■ The parity check code, because of being applied <u>after</u> channel modulation, has to be specially designed so that - besides allowing to identify all frequent error patterns at any location within the stream - its output remains compliant with the modulation constraints like min/max runlength (RLL) or maximum transition run (MTR). Consequently, a rate loss occurs, compared to parity-check codes designed for parity-check constraint alone.

■ The modulation decoder, also denoted as channel demodulator hereinafter, may cause error propagation, which makes the judgment of overall system performance difficult. Because of this error propagation, increasing the number of parities does not necessarily improve error correction performance - at least not if error correction performance is measured after the conventional error correction decoder that all these systems are assumed to have anyway.

The invention proposes a new approach, where the order of channel modulation and parity bit insertion is inverted: On the recording side, after conventional ECC encoding, parity bits aiming at typical error pattern correction are inserted first, after which the resulting bitstream is channel modulated. Correspondingly, at the readback side, the parity-based postprocessing takes place after channel demodulation.

The invention also relates to a parity check code which allows to identify and partly to locate the error patterns based on the parity syndromes.

Because of the proposed new order of processing steps, parity-based postprocessing can straightforwardly use soft outputs (for example, log-likelihood-ratio LLR reliabilities) from a soft-decision modulation decoder or from a joint (bit detector+modulation decoder).

The invention describes a parity-based postprocessing method which derives missing error pattern localization, also denoted as error position information hereinafter, from the soft outputs, by tentatively applying the most probable error patterns by sign-flipping the associated LLR values, and analyzing the syndrome vector of the parity code to determine whether to retain or to undo the tentatively applied error pattern.

**Advantages**

■ With channel modulation being the last processing step on the recording side, channel constraints are automatically fulfilled without any code rate loss, irrespective of what kind of parity-check encoder is involved. Modulation constraints are maintained without extra code rate loss.

■ Improved system performance because dominant errors after modulation decoder are eliminated. Hence, after the conventional error correction decoder as well, a better error correction performance is to be expected. System performance enhancement is because dominant errors after modulation decoder are eliminated.

Consequently, better error correction performance than previous schemes after error correction decoder can be expected.

Drawings

Exemplary embodiments of the invention are illustrated in the drawings and are explained in more detail in the following description.

In the figures:

Fig. 1     shows a prior art system setup for post-detector processing.
Fig. 2     shows a system setup according to the invention.
Fig. 3     illustrates the error detection probability using a check pattern of [100100100...] for an error event {101}.
Fig. 4     shows parity-based post processing exploiting LLR values.

The prior art system setup shown in Fig. 1 can be seen to have the following drawbacks:

■ In order to maintain modulation constraints (e.g., runlength constraints) after parity-check encoder, a parity-check code has to be designed which fulfills modulation constraints and parity-check constraint simultaneously. Consequently, a code rate loss occurs, compared to parity-check codes designed for parity-check constraint alone (see "Parity-check codes and post-processing for d=1 optical recording channels," by Cai et al, IEEE Trans. Magn., vol. 41, pp. 4338-4340, Nov. 2005).

■ Alternatively, if general parity-check codes are used without taking modulation constraints into account, modulation constraints are likely to be violated after the parity-check encoder;

■ There is possible error propagation due to modulation decoder, which makes the judgment of overall system performance difficult. In "On the performance of parity-check codes in magnetic recording systems," by Feng et al, Proc. IEEE Globecom'00, pp. 1877-1881, it was observed that increasing the number of parities in a parity-check encoder does not necessarily result in a better error correction performance after error correction decoder, because of error propagation caused by the modulation decoder.

The current invention resolves these drawbacks of conventional parity-based post processing after bit detector. The current invention addresses

■ How to design simple parity-check codes to identify (i.e. detect the occurrence of) pre-determined error patterns;
■ How to perform parity-based error correction exploiting soft outputs from soft-decision modulation decoder (channel demodulator) or from a soft-decision joint bit detector/modulation decoder.

Parity-check encoders are designed to identify pre-determined error patterns, which are dominant error events after modulation decoder or joint bit detector/modulation decoder. Based on soft (reliability) information about data bits, corresponding to the payload bits before modulation encoding, and based on syndrome vectors evaluated according to the parity-check equations, error event type and its position are identified for error correction.

In the light of conventional parity-based post processing and its mentioned drawbacks, this invention realizes that the parity-check encoder should be placed before the modulation encoder rather than after it. Accordingly, parity-based post-processing according to this invention is carried out after the modulation decoder or the joint bit detector/modulation decoder. Such a system setup according to the present invention is illustrated in Fig. 2. An obvious advantage is that modulation constraints are always and automatically satisfied without any code rate loss, irrespective of what kind of parity-check encoder is involved.

Fig. 2 shows a system setup according to the invention, where parity-based postprocessing is done after the modulation decoder.

**Design of parity-check codes for error type identification**

In the sequel, let k and n denote infoword length and codeword length for a parity check code. Infoword and codeword are denoted as $\underline{u}$=[u1, u2, ..., uk]^T and $\underline{c}$=[c1, c2, ..., cn]^T, respectively. That is, a parity check code actually defines the mapping rule between $\underline{u}$ and $\underline{c}$. In this, the notation "[]^T" shall denote the transpose operation of a row or column vector "[ ]".

As a special class of linear block codes, a parity-check code can also be defined by its parity-check matrix H due to H$\underline{c}$=0. For example, the binary, systematic single parity-check code can be defined as c1=u1, c2=u2, ..., ck=uk, cn=mod(u1+u2+...+uk, 2) with n=k+1 and mod(x, 2) denoting a module-2 operation of x. The corresponding parity-check matrix is just a single all-one 1 xn vector, i.e., H=[1 1 1... 1] and H$\underline{c}$=$\underline{0}$ (module 2).

After modulation decoder, there are possible errors imposed on codewords of parity check code. Let $\underline{e}$ denote a possible error vector. If the syndrome vector $\underline{s}$=H($\underline{c}$+$\underline{e}$)=H$\underline{e}$ is not equal to zero, then $\underline{e}$ is said to be a detectable error event. In the case of single parity-check code, all error events of odd weights (here weight means the number of "1"s in the error vector) can be detected due to nonzero syndrome vector.

**Error detection using periodical check patterns**

In "Detection of prescribed error events: Application to perpendicular recording," J. Moon et al, pp. 2057-2062, Proc. IEEE ICC'05, periodical binary check patterns of different shifts (also referred to as phases hereafter) are used to detect pre-determined error events. For clarity, the following examples are used to show the basic idea therein:

i). Assuming that a single bit error happens, denoted as {1} ("1" denotes an error bit), a binary check pattern [1111...] with period one can always detect this error event. That is, the parity check sum of all payload bits is always equal to 1, irrespective of the bit error position in the error vector.

ii). Assuming that an error event of length 2 happens, denoted as {11}, then the check pattern [101010...] with period two is capable to detect this error event, independent of the error position.

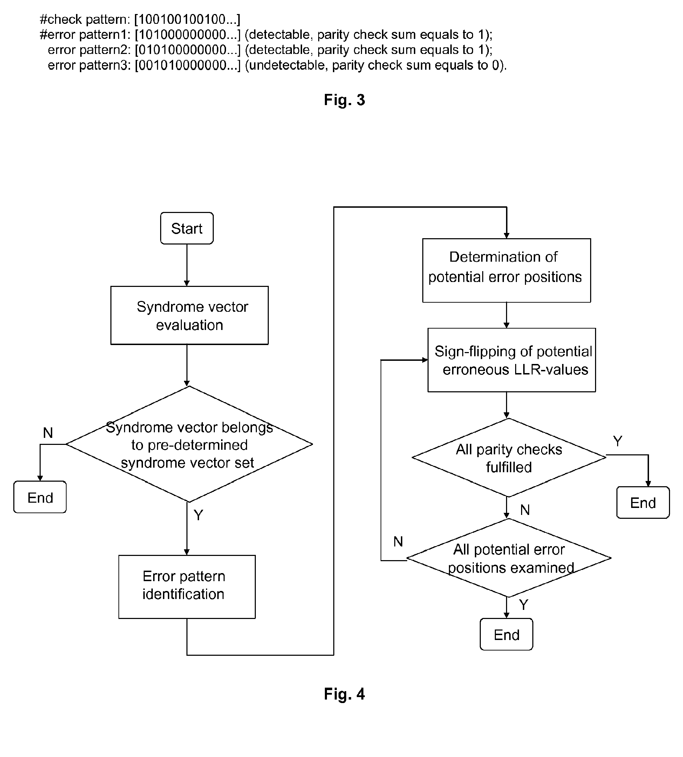

iii). Consider error events of length 3. There are two distinct such error events, namely {111} and {101}. For the error event {111}, the binary pattern [100100100...] of period three can detect this event at any arbitrary position. On the other hand, for the error event {101}, the error detection probability using check pattern [100100100...] is 2/3 as obvious from Fig. 3. With other words, using a check pattern [100100100...], an error event {101} will only be detected in 2 of its 3 possible relative positions. Fig. 3 illustrates the error detection probability using a check pattern [100100100...]. Depending on the relative position between the error event and the check pattern, the error event {101} can be either detected or not.

In order to reliably detect both error events of length 3, one more check pattern is necessary, which is a shifted version of [100100100...], for example [001001001...]. These two check patterns may be interpreted as two "phases" of check pattern [100100100...], and since they must both be implemented, they also constitute two rows of the corresponding parity-check matrix. That is, two parity-check bits are necessary for error detection. Given these two check patterns, the syndrome vector for the error event {111} is [11]^T. The syndrome vector for the error event {101} is [11]^T or [01]^T, depending on the position of the error event.

In general, for an arbitrary error event of length L, L phases of a periodical check pattern

$$[1\ 0^{\wedge}(L-1)\ 1\ 0^{\wedge}(L-1)\ ...]$$

are sufficient to detect the error event at any position. In this, the notation "0^(L-1)" shall denote that "0" is repeated (L-1) times. Using L phases of the check pattern

$$[1\ 0^{\wedge}(L-1)\ 1\ 0^{\wedge}(L-1)\ ...]$$

to constitute L rows of a parity-check matrix, the syndrome vector is non-zero for an arbitrary error event of length L.

**Parity-check code design for error type identification**

In "Detection of prescribed error events: Application to perpendicular recording," J. Moon et al, pp. 2057-2062, Proc. IEEE ICC'05, the post-processing is carried out after bit detector. Parity-check codes are designed only for error detection.

For post processing after the modulation decoder (embodied as RLL decoding), as this invention proposes, it is advantageous to design parity-check codes that are additionally capable of identifying and if possible also locating error types. For the task of identifying error patterns according to syndrome vectors, given that the set of error patterns is known a priori (i.e., dominant error events have been determined before parity-check code design), in the following, a design process for error identification parity-check codes is described in detail.

Assuming that the maximum length of dominant error events is Lm, an mxq basic check pattern matrix Hb is constructed firstly, where m=sum(1:Lm) denotes its number of rows, and q=lcm(1:Lm) denotes its number of columns. In this, "sum(a:b)" shall denote the sum of all integers from a to b, and "lcm(a:b)" shall denote the least common multiple for integers from a to b.

Rows of the check pattern matrix Hb are determined as different phases of the check patterns

$$[1\ 0^i\ 1\ 0^i...]\ \text{with}\ 0<=i<=Lm-1.$$

The zero-runlength "i" in "[1 0^i 1 0^i...]" is constant within each group of rows describing different phases of the same check pattern. Going down the rows of Hb, "i" takes on values 0, 1, 1, 2, 2, 2, 3, 3, 3, 3, ...

The resulting check pattern matrix Hb is capable to detect all error events of length up to Lm, at least if the error events lie completely within the check window of length n. As a result of this property of Hb, a parity-check matrix H can be constructed by repeated concatenation of Hb, H being capable to detect all error events, irrespective of their positions within the codeword.

For Lm=3, m=sum(1:3)=6 and q=lcm(1:3)=6, the check pattern matrix results as:

$$\mathbf{H}b = \begin{bmatrix} 1 & 1 & 1 & 1 & 1 & 1 \\ 1 & 0 & 1 & 0 & 1 & 0 \\ 0 & 1 & 0 & 1 & 0 & 1 \\ 1 & 0 & 0 & 1 & 0 & 0 \\ 0 & 1 & 0 & 0 & 1 & 0 \\ 0 & 0 & 1 & 0 & 0 & 1 \end{bmatrix}.$$

Note that this check pattern matrix Hb possibly is redundant for error pattern identification. Therefore, the next step is to find the minimum number of parity checks and the corresponding parity-check equations, being a subset of those contained in Hb, which are sufficient but not redundant to identify all error patterns in the given error pattern set.

Sufficient and necessary conditions for error pattern identification are

■ Condition 1). All syndrome vectors are non-zero for all error patterns in the error pattern set, irrespective of their positions.

■ Condition 2). Syndrome vectors are distinct for any two different error patterns from the error pattern set.

Given the matrix Hb, the minimum number of parity checks can be found for example by gradually increasing the number of parity checks from 1 to m. That is, firstly each row in Hb is examined to check whether the above mentioned two conditions for error pattern identification are satisfied. If not, all combinations of two rows in Hb are examined; thereafter, all combinations of three rows are examined; this search procedure is repeated until the two conditions for error identification are met.

For example, assume that there are three dominant error events {1}, {11}, {111} after modulation decoder. A suitable check pattern matrix with the minimum number of parity checks is then found as

$$\mathbf{H}_1 = \begin{bmatrix} 1 & 0 & 0 & 1 & 0 & 0 \\ 0 & 1 & 0 & 0 & 1 & 0 \\ 0 & 0 & 1 & 0 & 0 & 1 \end{bmatrix}$$

Looking at the error events one by one, the corresponding syndrome vectors evaluate as follows:

(i). Error event {1}:

$$\mathbf{s}_{1,1} = \mathbf{H}_1 \begin{bmatrix} 100000 \end{bmatrix}^T = \begin{bmatrix} 100 \end{bmatrix}^T, \; \mathbf{s}_{1,2} = \mathbf{H}_1 \begin{bmatrix} 010000 \end{bmatrix}^T = \begin{bmatrix} 010 \end{bmatrix}^T, \; \mathbf{s}_{1,3} = \mathbf{H}_1 \begin{bmatrix} 001000 \end{bmatrix}^T = \begin{bmatrix} 001 \end{bmatrix}^T,$$

$$\mathbf{s}_{1,4} = \mathbf{H}_1 \begin{bmatrix} 000100 \end{bmatrix}^T = \begin{bmatrix} 100 \end{bmatrix}^T = \mathbf{s}_{1,1}, \; ....$$

That is, three syndrome vectors exist for the error event {1}, namely, [100]^T, [010]^T, or [001]^T, depending on its position relative to the check patterns defined in H1. In this and hereinafter, the notion of $\mathbf{s}_{i,j}$ denotes the syndrome vector for the i-th error pattern with a circular right shift of "(j-1)" bits, where 1 <=j<=q.

(ii). Error event {11}:

For the error event {11}, syndrome vectors can similarly be evaluated as for the error event {1}. It is found that three syndrome vectors exist, namely, [110]^T, [011]^T, and [101]^T.

(iii). For the error event {111}, there is only one syndrome vector [111]^T, irrespective of where the error event occurs.

For these three error events, syndrome vectors are non-zero, and they are distinct, independent of positions of error events within the check window. Therefore, H1 defines a suitable check pattern matrix for error pattern identification. The suitable parity-check matrix for error pattern identification is just a repeated concatenation of H1, depending on the codeword length, i.e., H=[H1, H1, ...].
For a systematic code with an infoword u=[u1, u2, ..., uk]^T, three parity-check bits may be calculated as follows:

$$p1=(u1+u4+u7+...) \; module\text{-}2$$

$$p2=(u2+u5+u8+...) \; module\text{-}2$$

$$p3=(u3+u6+u9+...) \; module\text{-}2,$$

and the codeword is obtained as c=[u1, u2, ..., uk, p1, p2, p3]^T. For this case, the corresponding parity-check matrix is H=[H1, H1, H1, ..., I] where I denotes a 3x3 identity matrix.
In summary, a suitable parity-check code for error type identification is derived with the following three steps:

**Step (A1):** Given pre-determined dominant error events, construct a check pattern matrix Hb of dimension mxq with m=sum(1:Lm), q=lcm(1:Lm). The rows of Hb are different phases of check patterns [1 0^i 1 0^i ...] with 0<=i<=Lm-1. Lm is the maximum length of error events.

**Step (A2):** Find a suitable combination of minimum number of rows in Hb, such that all error events can be identified, if error events are within the check window of length q=lcm(1:Lm).

**Step (A3):** Repeatedly concatenate Hb to obtain a suitable parity-check matrix H capable of identifying error events, irrespective of their positions.

Because of the periodic structure of parity-check matrix, both encoding and evaluation of syndrome vector are straightforward.

**Parity-based post-processing using soft decisions**

Fig. 4 shows Parity-based post processing exploiting LLR values which originate either from a soft-in soft-out modulation decoder or from a soft-in soft-out joint bit detector/modulation decoder.
Soft-in soft-out modulation decoding or soft-in soft-out joint bit detection/modulation decoding provide soft decisions about data bits corresponding to payload bits before the modulation encoding. A commonly used soft decision is the log-likelihood ratio (LLR) defined as

$$L(c_i) = \log \frac{P(c_i = 0 \mid \mathbf{r})}{P(c_i = 1 \mid \mathbf{r})},$$

In this, the sign of the LLR value corresponds to the hard decision about $c_i$, i.e. of the code bits of the parity-check codeword, equal to info bits of the modulation encoder, and r is the soft-in vector to the modulation decoder or joint bit detector/modulation decoder.
The magnitude of the LLR value gives the reliability of the hard decision, where LLR values with a small magnitude ("unreliable") indicate potential errors. Therefore, potential error positions can be determined according to magnitudes of LLR values.
Post-processing for error correction is carried out by sign-flipping of potentially erroneous LLR values with small magnitudes and examining parity-check equations after sign-flipping. If parity-check equations are fulfilled after sign-flipping, dominant errors are corrected with a high probability.
The flow chart of soft-decision parity-based post processing is shown in Fig. 4, which is explained in detail as the following steps:

**Step B1)** *Syndrome vector evaluation*

As mentioned before, signs of LLR values correspond to hard decisions, which are used for evaluation of syndrome vector.

**Step B2)** *Error pattern identification*

As discussed previously, each pre-determined error event results in a few syndrome vectors dependent on error positions. And the parity-check code is designed such that different error patterns have distinct syndrome vectors. Hence, based on the syndrome vector calculated in Step B1), the error pattern can be identified. If the calculated syndrome vector does not match to any syndrome vector corresponding to predetermined error events, no post-processing takes place. On the other hand, the parity-check code is designed for dominant error events. Hence, the probability for an unidentifiable error is low.

**Step B3)** *Determination of potential error positions*

According to magnitudes of LLR values, potential error positions can be determined. For example, all LLR values with magnitude below a pre-defined threshold are flagged as potentially erroneous LLR values, i.e., potential error positions. Alternatively, a list of least reliable LLR values (LLR values having the smallest magnitudes) is flagged as potential erroneous LLR values. The choice of the threshold or the list size enables that a trade-off between performance and computational complexity is selected.

**Step B4)** *Sign-flipping of potentially erroneous LLR values*

Potential error positions determined in Step B3) are examined successively. If a combination of potential error positions matches to the error pattern identified in Step B2), then signs of LLR values at the corresponding positions are flipped.

After sign-flipping, parity-check equations are examined again. If all parity-check equations are fulfilled, i.e., the syndrome vector becomes all-zero vector, post-processing is accomplished and the flipped signs are retained. Otherwise, other potential error positions are examined as in Step B4), until all positions have been examined.

The invention can be applied in all kinds of communication systems.

### About error propagation due to the modulation decoder i.e. channel demodulator

Prior art places the parity-check code after the RLL encoder, i.e., attention is paid to error patterns after bit detector and before the RLL decoder.

The setup of the present invention is different, see Fig. 2. Error patterns are detected and corrected after the modulation decoder / channel demodulator. With such a setup, error propagation due to modulation (RLL) decoder can be combatted to some extent. A further advantage of the structure shown in Fig. 2 is that it enables a joint bit detector/RLL decoder, which is the optimal receiver for the concatenation of RLL encoder and PR channel.

### About error pattern detection and localization

In this invention, the generated parity check codes are unique over some of the error patterns, i.e. observing a certain syndrome pattern allows to tell which of the error patterns has occurred. More than that, they also provide some - although not all - information about the position of the error pattern, in the sense of excluding some of the possible error pattern positions within the check window. For the example described above, at least within a single "Basic Check Pattern Matrix" H1, observing e.g. a syndrome set of [100] tells not only that the type of error event is {1}, but also that the position is 1 or 4 (but not 2 or 3). With other words: At least some position information is given. For an n-fold concatenation of H1, things are similar. In the case of the example, some position information can be provided for error patterns {1} and {11}. Available position information according to syndrome vector should be exploited during the error position identification process.

The remainder of the error position information is then derived from looking at the magnitudes of the LLR values from the channel demodulator, as described above.

### About error events that lie only partially within the check window

For error pattern sets comprising error patterns that contain "0" in some internal position, attention should be paid to the boundary between two adjacent basic check matrices Hb. During the syndrome evaluation, we have actually a sliding check window. If we combine the last columns of the first (leftmost) Hb and the first columns of the second (from left) Hb together, the resulting matrix can be obtained by simultaneous right-circular shifting of all rows in Hb. In mathematical notation, [Hb Hb]=[Hb1 Hb2 Hb3 Hb4], i.e., each of two cascaded basic check matrices is divided into two sub-matrices. The modified basic check matrix is obtained as Hb'=[Hb2 Hb3], which is obtained by simultaneous right-circular shifting of all rows in Hb and has the same number of columns as that of Hb.

Therefore, during the search procedure for a suitable basic check matrix, error patterns with all possible circular shifts should be tested to guarantee the identification of error patterns at the boundary of two basic check matrices.

### About identifying the smallest subset of parity equations of the parity check matrix (H) which is sufficient but not redundant to identify all error patterns in a given error pattern set

The minimum number of parity checks can be found by gradually increasing the number of parity checks from 1 to m. At maximum, with a brute force approach, all the 2^m combinations of using/not using the m rows of the check pattern matrix Hb must be checked. However, since not using any of the rows will never work, and using all of the rows will always work, only (2^m)-2 combinations must actually be checked. Using the described search strategy and assuming that m' parity-checks are necessary, the number of combinations to be checked is equal or less than

$$\binom{m}{1}+\binom{m}{2}+...+\binom{m}{m'},$$

because there may be more than one suitable parity-check matrices with m' rows. If one suitable combination of m' rows has been found, the search procedure stops. And in the worst case, (2^m)-2 combinations have to be checked.

In situations where nearly all check patterns are "needed", the method may as well gradually reduce the number of used parity equations down from m to m'. This of course assumes that when for a certain number m" none of the combinations of m" rows fulfills the conditions, it can be concluded that all shorter combinations using m'''<m" rows will as well fail the condition test. This assumption may not be true, depending on the error pattern set.

However, it may be quicker to check combinations of "1" row out of "m" rows than to check combinations of "(m-1)" rows out of "m" rows, despite the fact that in both cases there are "m" such combinations. The reason is that the evaluation of syndrome vectors is more complicated using a parity-check matrix having "(m-1)" rows than using a parity-check matrix having "1" row.

**About other applications of the parity check construction method**

The parity check construction method described herein can as well be used in a prior art system according to Fig. 1. This acknowledges that the task of identifying the error pattern is independent of where in the signal path the parity-based postprocessing takes place.

**About which error patterns should be tested**

If during the search procedure for a suitable basic check matrix, error patterns with all possible circular shifts are tested, it can be argued that this is correct at least at the "inner boundaries" of neighboring Hb's within a single parity-check matrix. Considering the example of error event {101}, having a {1} at the right end of one Hb implies that the right neighbor Hb receives the remaining {01} at its left end, so the "circularly designed" parity will work. However, things are different in those cases where a truncated error event appears at the very beginning or very end of the parity-check window, i.e. at the beginning or end of a <u>codeword.</u> At the boundary of codewords, one should be careful, although the probability that error patterns appear at that boundary is low for a sufficiently long codeword. A dedicated boundary procedure may be advantageous to deal with this problem. One possible boundary procedure is as follows:

We observe the magnitudes of LLR values at the boundary region of two adjacent codewords. The potential error positions are associated with a small LLR magnitude. Then we check whether there is a matching between the potential error positions and pre-determined error patterns. For this boundary region, we do exhaustive search over all possible error patterns.

Due to the low probability for error patterns appearing at the boundary and due to the short length of error patterns, the additional complexity for this kind of post processing is expected to be low.

**About how to derive error position information**

"A graph-based construction of high-rate soft decodable codes for partial response channels", B. Vasic, IEEE ICC 2001, pp 2716ff, hereinafter "Vasic", discloses "By using the syndrome calculated for a received codeword, we create a list of all possible positions where error events might have occurred, and then use error event likelihoods to select the most likely position and most likely type of error event".

The post-processing approach in Vasic is similar as in other prior art, namely having parity-check encoder <u>after</u> the RLL encoder. This implies that post-processing is based on bit detector, which provides a sequence estimate in the maximum-likelihood sense. Hence, in Vasic, the determination of error type, polarity, position is based on the Euclidean distance between bit detector input signal and the reconstructed PR signal sequence using the ML sequence estimate and possible error patterns at all possible positions, see Section IV, p. 2719.

Let y denote the bit detector input signal and c the ML sequence estimate after bit detector. For each error pattern in the error pattern set, say e', Euclidean distances $|y-(c+e(j))*h|^2$ are evaluated for all possible beginning positions of e'. In this, "e(j)" shall denote an error vector corresponding to e', which has the same length as y , i.e., e(j) =[0,...,0, e', 0,...0] with e' beginning at position j. "(c+e(j))*h" shall denote the reconstructed PR signal. A smaller Euclidean distance indicates a more likely error pattern with the corresponding polarity, type, and position. This is equivalent to what was stated in Section IV of Vasic.

In contrast, this invention assumes a SISO decoder, which provides the estimated probability or equivalent LLR value for each bit (obtained for example using Log-MAP, Max-Log-MAP, or SOVA algorithms). Rather than using hard decisions as in priori art (the ML sequence estimate is a hard decision sequence) and reconstructing a PR signal ((c+e(j))*h), this invention determines potential positions using a threshold for LLR magnitudes and checks whether there is a match between potential error positions and the identified error pattern.

To illustrate this by an example, assume that, from the SISO decoder, LLR values are obtained as [8, 9, 0.5, -0.3, -0.4, 7], and the corresponding hard decision (signs of LLR values) is [+1 +1 +1 -1 -1 1]. For evaluation of syndrome vector, a mapping +1->0 and -1->1 is assumed, i.e., [000110] is used in parity-check evaluation. And it is further assumed that the syndrome vector is nonzero, i.e., there is an error event. With a magnitude threshold 1 (the threshold can be designed as a factor larger than 1 times the minimum LLR magnitude), positions 3, 4, and 5 are flagged as potential error positions. Based on the syndrome vector, the error event is assumed to be identified as {101}, for example, which indicates that errors occur at positions 3 and 5, but not at position 4. Accordingly, LLR values are changed to [8, 9, -0.5, -0.3, 0.4, 7] (sign-flipping of potential erroneous LLR values). Then, if the syndrome vector becomes zero after this sign-flipping, two bit errors are corrected.

In this example, the error event {101} only says that there are two bit errors, but nothing about the polarity of errors. Here "polarity" means whether an error of "0 transmitted and 1 decided" or an error of "1 transmitted and 0 decided" occurs. If such "polarity" information is available, it should be embedded in the error position search procedure. For example, it is assumed that only two possibilities for the event {101} exist, namely, {+0+} ("+" means that 1 is transmitted and 0 is decided, and "-" means that 0 is transmitted and 1 is decided) and {-0-}. If we compare the LLR values [0.5, -0.3, -0.4] to these two error patterns, there is no match, since the only possible error pattern for [0.5, -0.3, -0.4] will be {+0-}. Note that [0.5,-0.3,-0.4] is decided as [0 1 1], and its counterpart after sign-flipping, [-0.5,-0.3,0.4] is decided as [1 1 0]. Therefore, the identified error pattern will be {+0-}.

In summary, Vasic approach has the disadvantages of prior-art systems. With respect to post-processing, this invention has a lower complexity. Error identification parity check code may require higher redundancy (lower rate) than error detection parity check code, because of better performance at the expense of rate loss. The invention contributes to a better trade-off between redundancy and performance.

It may be argued, that nobody has thought before about interchanging the order of channel (RLL) coding and parity coding, because

∎ People have (assumedly) observed, that at the very output of PRML detection, certain error patterns occur pronouncedly more often than others.
∎ Acknowledging this, they have devised parity check coding as a way to fight these typical error patterns, and of course the measure was implemented in the exact location, where the error patterns were being observed, namely after channel encoding / before channel decoding.

This invention does not suppose a different error injection mechanism than what is assumed in prior art to cause the typical error patterns. Aiming to fight the typical errors at a different location in the block diagram, namely between channel decoder and ECC decoder, it may be advantageous to assume and consider different kinds of "typical error patterns". With other words and as an example: Assuming "101" as the most frequent error pattern at the input of the channel decoder, this will translate into a different corresponding most frequent error pattern at its output. Typical (dominant) error patterns after RLL decoding can be obtained by means of computer search. An analytical determination of dominant error patterns is difficult for complicated PR-targets.

Firstly, dominant error patterns result in smaller path metric difference (i.e., more prone to noise). That is the reason why some error patterns occur more often than others. Consider one path in the Viterbi trellis corresponding to the actually transmitted bit sequence and another path corresponding to a different bit sequence. If the path metric difference between these two paths is small, it is more possible that the wrong path is decided as the transmitted one. That is, the corresponding error pattern (as module-2 addition of two bit sequences) occurs more probable than others. Typically, theoretical analysis is only possible for very simple PR channels like PR[1 0 -1], or PR11. For complicated PR channels like PR1221 or PR12221, only simulative approach is possible, i.e. computer search method.

Secondly, the motivation for the invention comes from an approach of joint bit detection/RLL decoding. In this context, we may consider RLL-encoder and PR-channel together as a super-channel. Similar as PRML, which only considers PR-channel alone and the parity-check code is set before the PR-channel, parity-check code is allocated before the super-channel in the presence of joint bit detector/RLL decoder.

Similar as in the PRML case, analytically determining the dominant error patterns requires to investigate the distance spectra of this super-channel. Again, for complicated PR-channels, the computer search approach seems to be the only possibility.

Possibly, dominant error patterns after the joint bit detector/RLL decoder are different from dominant error patterns after the bit detector.

For PR1221 and an RLL code with d=1 constraint, dominant errors after bit detector are {1}, {101}, {10101}, while after joint bit detector/RLL decoder dominant error patters are {1}, {11}, {111}.

Notice that dominant error patterns after bit detector are only dependent on PR-channel alone (taking d-constraint of RLL codes into account), while dominant error patterns after joint bit detector/RLL decoder depend on both RLL encoder and PR-channel.

Another prejudice against investigating the system setup as in this invention may be that previously, RLL decoder is realized by means of simple digital logics (hard-input hard-output decoder, either based on table look-up or bounded block method) even for FSM decodable RLL codes. In such a setting, it is difficult to perform parity-check based post-processing after RLL decoder.

**Claims**

1. A method of encoding a bitstream, the method comprising a channel modulation, an ECC encoding and a parity bit insertion, and
**characterized in that** the parity bit insertion is performed after the ECC encoding and before the channel modulation.

2. The method of claim 1, wherein an RLL encoding is used as the channel modulation.

3. A method for decoding a bitstream that has been encoded according to the method of claim 1, the method comprising a channel demodulation, an ECC decoding and a parity bit evaluation, and
**characterized in that** the parity bit evaluation is peformed after the channel demodulation and before the ECC decoding.

4. The method of claim 3, wherein an RLL decoding is used as the channel demodulation.

5. A method for decoding according to claim 3, wherein a reliability information from the channel demodulation is forwarded and used in the parity bit evaluation.

6. The method of claim 5, wherein an error position information is derived from the reliability information, a set of most probable error patterns are tentatively applied by inverting associated bits of the bitstream and by calculating an associated syndrome vector therefor, and where the syndrome vectors are analyzed to determine whether to retain or to undo the applied error pattern.

7. Method for generating a parity check matrix (H) for use in the parity bit insertion step of claim 1, comprising

- determining a basic check pattern matrix (Hb) having rows that are constituted by different phases of periodic check patterns,
- constructing the parity check matrix (H) by repeated concatenation of the basic check pattern matrix (Hb),
- identifying a smallest subset of parity equations of the parity check matrix (H) which is sufficient but not redundant to identify all error patterns in a given error pattern set, by checking whether the subset satisfies an error pattern identification condition.

8. The method of claim 7, wherein the error pattern identification condition is embodied by checking that all syndrome vectors are non-zero for all error patterns in the error pattern set, irrespective of their positions, and that syndrome vectors are distinct for any two different error patterns from the error pattern set.

```
┌─────────────────┐   ┌─────────────────┐   ┌─────────────────┐   ┌─────────────────┐
│ Error correction│→  │   Modulation    │→  │  Parity-check   │→  │    Precoder     │
│     encoder     │   │    encoder      │   │    encoder      │   │                 │
└─────────────────┘   └─────────────────┘   └─────────────────┘   └─────────────────┘
                                                                           │
                                                                           ↓
                                                                  ┌─────────────────┐
                                                                  │   Write/read    │
                                                                  │    channel      │
                                                                  └─────────────────┘
                                                                           │
                                                                           ↓
┌─────────────────┐   ┌─────────────────┐   ┌─────────────────┐   ┌─────────────────┐
│ Error correction│←  │   Modulation    │←  │  Parity-based   │←  │   Bit detector  │
│     decoder     │   │    decoder      │   │ post processor  │   │                 │
└─────────────────┘   └─────────────────┘   └─────────────────┘   └─────────────────┘
```

**Fig. 1**

```
┌─────────────────┐   ┌─────────────────┐   ┌─────────────────┐   ┌─────────────────┐
│ Error correction│→  │  Parity-check   │→  │   Modulation    │→  │    Precoder     │
│     encoder     │   │    encoder      │   │    encoder      │   │                 │
└─────────────────┘   └─────────────────┘   └─────────────────┘   └─────────────────┘
                                                                           │
                                                                           ↓
                                                                  ┌─────────────────┐
                                                                  │   Write/read    │
                                                                  │    channel      │
                                                                  └─────────────────┘
                                                                           │
                                                                           ↓
┌─────────────────┐   ┌─────────────────┐   ┌─────────────────┐   ┌─────────────────┐
│ Error correction│←  │  Parity-based   │←  │   Modulation    │←  │   Bit detector  │
│     decoder     │   │ post processor  │   │    decoder      │   │                 │
└─────────────────┘   └─────────────────┘   └─────────────────┘   └─────────────────┘
```

**Fig. 2**

#check pattern: [100100100100...]
#error pattern1: [101000000000...] (detectable, parity check sum equals to 1);
  error pattern2: [010100000000...] (detectable, parity check sum equals to 1);
  error pattern3: [001010000000...] (undetectable, parity check sum equals to 0).

**Fig. 3**

**Fig. 4**

Europäisches
Patentamt

European
Patent Office

Office européen
des brevets

# EUROPEAN SEARCH REPORT

Application Number

EP 08 30 5613

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 0 673 031 A (SONY CORP [JP]) 20 September 1995 (1995-09-20) * figure 5 * | 1-4 | INV. G11B20/14 |
| X | GB 2 329 510 A (SONY CORP [JP]) 24 March 1999 (1999-03-24) * figure 4 * | 1-4 | |
| X | US 2006/080587 A1 (MOON JAEKYUN [US] ET AL) 13 April 2006 (2006-04-13) * the whole document * | 7,8 | |
| X | US 2008/028274 A1 (LIN SHU [US]) 31 January 2008 (2008-01-31) * the whole document * | 5,6 | |
| D,A | CIDECIYAN R D ET AL: "NOISE PREDICTIVE MAXIMUM LIKELIHOOD DETECTION COMBINED WITH PARITY-BASED POST-PROCESSING" IEEE TRANSACTIONS ON MAGNETICS, IEEE SERVICE CENTER, NEW YORK, NY, US, vol. 37, no. 2, PART 01, 1 March 2001 (2001-03-01), pages 714-720, XP001006948 ISSN: 0018-9464 * the whole document * | | **TECHNICAL FIELDS SEARCHED (IPC)** G11B |
| D,A | CAI K ET AL: "Parity-check codes and post-processing for d=1 optical recording channels" IEEE TRANSACTIONS ON MAGNETICS IEEE USA, vol. 41, no. 11, November 2005 (2005-11), pages 4338-4340, XP002507460 ISSN: 0018-9464 * the whole document * | | |

-/--

The present search report has been drawn up for all claims

| Place of search | Date of completion of the search | Examiner |
|---|---|---|
| Munich | 23 February 2009 | Barel-Faucheux, C |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches Patentamt
European Patent Office
Office européen des brevets

# EUROPEAN SEARCH REPORT

**Application Number**

EP 08 30 5613

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| D,A | US 6 581 184 B1 (SAEKI KOSHIRO [US] ET AL) 17 June 2003 (2003-06-17) * the whole document * | | |
| D,A | FENG W ET AL: "ON THE PERFORMANCE OF PARITY CODES IN MAGNETIC RECORDING SYSTEMS" GLOBECOM'00. 2000 IEEE GLOBAL TELECOMMUNICATIONS CONFERENCE. SAN FRANCISCO, CA, NOV. 27 - DEC. 1, 2000; [IEEE GLOBAL TELECOMMUNICATIONS CONFERENCE], NEW YORK, NY : IEEE, US, vol. 3, 27 November 2000 (2000-11-27), pages 1877-1881, XP001195752 ISBN: 978-0-7803-6452-3 * the whole document * | | |
| D,A | JAEKYUN MOON ET AL: "Detection of prescribed error events: application to perpendicular recording" COMMUNICATIONS, 2005. ICC 2005. 2005 IEEE INTERNATIONAL CONFERENCE ON SEOUL, KOREA 16-20 MAY 2005, PISCATAWAY, NJ, USA,IEEE, vol. 3, 16 May 2005 (2005-05-16), pages 2057-2062, XP010826233 ISBN: 978-0-7803-8938-0 * the whole document * | | TECHNICAL FIELDS SEARCHED (IPC) |

-/--

The present search report has been drawn up for all claims

| Place of search | Date of completion of the search | Examiner |
|---|---|---|
| Munich | 23 February 2009 | Barel-Faucheux, C |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

Europäisches
Patentamt

European
Patent Office

Office européen
des brevets

# EUROPEAN SEARCH REPORT

Application Number

EP 08 30 5613

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| D,A | VASIC B ED  - INSTITUTE OF ELECTRICAL AND ELECTRONICS ENGINEERS:  "A graph based construction of high-rate soft decodable codes for partial response channels" ICC 2001. 2001 IEEE INTERNATIONAL CONFERENCE ON COMMUNICATIONS. CONFERENCE RECORD. HELSINKY, FINLAND, JUNE 11 - 14, 2001; [IEEE INTERNATIONAL CONFERENCE ON COMMUNICATIONS], NEW YORK, NY : IEEE, US, vol. 9, 11 June 2001 (2001-06-11), pages 2716-2720, XP010553620 ISBN: 978-0-7803-7097-5 * the whole document * ----- | | |
| A | KEES A SCHOUHAMER IMMINK:  "A Practical Method for Approaching the Channel Capacity of Constrained Channels" IEEE TRANSACTIONS ON INFORMATION THEORY, IEEE, US, vol. 43, no. 5, 1 September 1997 (1997-09-01), XP011026895 ISSN: 0018-9448 * the whole document * ----- | | TECHNICAL FIELDS SEARCHED      (IPC) |

The present search report has been drawn up for all claims

| Place of search | Date of completion of the search | Examiner |
|---|---|---|
| Munich | 23 February 2009 | Barel-Faucheux, C |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

.......................................................................................
& : member of the same patent family, corresponding
    document

EPO FORM 1503 03.82 (P04C01)

Europäisches
Patentamt

European
Patent Office

Office européen
des brevets

Application Number

EP 08 30 5613

## CLAIMS INCURRING FEES

The present European patent application comprised at the time of filing claims for which payment was due.

☐ Only part of the claims have been paid within the prescribed time limit. The present European search report has been drawn up for those claims for which no payment was due and for those claims for which claims fees have been paid, namely claim(s):

☐ No claims fees have been paid within the prescribed time limit. The present European search report has been drawn up for those claims for which no payment was due.

## LACK OF UNITY OF INVENTION

The Search Division considers that the present European patent application does not comply with the requirements of unity of invention and relates to several inventions or groups of inventions, namely:

see sheet B

☒ All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☐ None of the further search fees have been paid within the fixed time limit. The present European search report has been drawn up for those parts of the European patent application which relate to the invention first mentioned in the claims, namely claims:

☐ The present supplementary European search report has been drawn up for those parts of the European patent application which relate to the invention first mentioned in the claims (Rule 164 (1) EPC).

Europäisches
Patentamt

European
Patent Office

Office européen
des brevets

**LACK OF UNITY OF INVENTION
SHEET B**

Application Number

EP 08 30 5613

The Search Division considers that the present European patentapplication does not comply with the requirements of unity of invention and relates to severalinventions or groups of inventions, namely:

1. claims: 1-4

    Claim 1 defines "A method of encoding a bitstream, the method comprising a channel modulation, an ECC encoding and a parity bit insertion, and
    characterized in that the parity bit insertion is performed after the ECC encoding and before the channel modulation."
    Claim 3 defines "A method for decoding a bitstream that has been encoded according to the method of claim 1, the method comprising a channel demodulation, an ECC decoding and a parity bit evaluation, and
    characterized in that the parity bit evaluation is peformed after the channel demodulation and before the ECC decoding."
    ---

2. claims: 7,8

    Claim 7 defines a "Method for generating a parity check matrix (H) [suitable] for use in the parity bit insertion step of claim 1, comprising
    - determining a basic check pattern matrix (Hb) having rows that are constituted by different phases of periodic check patterns,
    - constructing the parity check matrix (H) by repeated concatenation of the basic check pattern matrix (Hb),
    - identifying a smallest subset of parity equations of the parity check matrix (H) which is sufficient but not redundant to identify all error patterns in a given error pattern set, by checking whether the subset satisfies an error pattern identification condition."
    whereas claim 8 defines "The method of claim 7, wherein the error pattern identification condition is embodied by checking that all syndrome vectors are non-zero for all error patterns in the error pattern set, irrespective of their positions, and that syndrome vectors are distinct for any two different error patterns from the error pattern set."
    ---

3. claims: 5, 6

Europäisches
Patentamt

European
Patent Office

Office européen
des brevets

**LACK OF UNITY OF INVENTION
SHEET B**

Application Number

EP 08 30 5613

The Search Division considers that the present European patentapplication does not comply with the requirements of unity of invention and relates to severalinventions or groups of inventions, namely:

Claim 5 defines "A method for decoding according to claim 3, wherein a reliability information from the channel demodulation is forwarded and used in the parity bit evaluation."

whereas claim 6 defines "The method of claim 5, wherein an error position information is derived from the reliability information, a set of most probable error patterns are tentatively applied by inverting associated bits of the bitstream and by calculating an associated syndrome vector therefor, and where the syndrome vectors are analyzed to determine whether to retain or to undo the applied error pattern."

---

**ANNEX TO THE EUROPEAN SEARCH REPORT
ON EUROPEAN PATENT APPLICATION NO.**

EP 08 30 5613

This annex lists the patent family members relating to the patent documents cited in the above-mentioned European search report.
The members are as contained in the European Patent Office EDP file on
The European Patent Office is in no way liable for these particulars which are merely given for the purpose of information.

23-02-2009

| Patent document cited in search report | | Publication date | Patent family member(s) | | Publication date |
|---|---|---|---|---|---|
| EP 0673031 | A | 20-09-1995 | CN 1119321 A | | 27-03-1996 |
| | | | DE 69522128 D1 | | 20-09-2001 |
| | | | DE 69522128 T2 | | 21-03-2002 |
| | | | JP 3482676 B2 | | 22-12-2003 |
| | | | JP 7254236 A | | 03-10-1995 |
| | | | US 5559644 A | | 24-09-1996 |
| GB 2329510 | A | 24-03-1999 | JP 11154377 A | | 08-06-1999 |
| | | | US 6172829 B1 | | 09-01-2001 |
| US 2006080587 | A1 | 13-04-2006 | NONE | | |
| US 2008028274 | A1 | 31-01-2008 | US 2008126908 A1 | | 29-05-2008 |
| US 6581184 | B1 | 17-06-2003 | NONE | | |

For more details about this annex : see Official Journal of the European Patent Office, No. 12/82

## REFERENCES CITED IN THE DESCRIPTION

**Patent documents cited in the description**

- US 6581184 B

**Non-patent literature cited in the description**

- **Cideciyan et al.** Noise predictive maximum likelihood detection combined with parity-check based post processing. *IEEE Trans. Magn.,* March 2001, vol. 37, 714-720
- **Cai et al.** Parity-check codes and post-processing for d=1 optical recording channels. *IEEE Trans. Magn.,* November 2005, vol. 41, 4338-4340
- **Feng et al.** On the performance of parity-check codes in magnetic recording systems. *Proc. IEEE Globecom'00,* 1877-1881
- **J. Moon et al.** Detection of prescribed error events: Application to perpendicular recording. *Proc. IEEE ICC'05,* 2057-2062
- **B. Vasic.** A graph-based construction of high-rate soft decodable codes for partial response channels. *IEEE ICC,* 2001, 2716ff